# EUROPEAN PATENT APPLICATION

(11) **EP 4 365 929 A1**
(43) Date of publication of application: **08.05.2024**
(21) Application number: 22845780.0
(22) Date of filing: 05.07.2022
(51) Int. Cl.: H01L 21/301, C08K 5/10, C08L 33/02, C08L 33/06

(54) **RESIN COMPOSITION FOR DICING PROTECTION LAYER AND TREATMENT METHOD FOR SEMICONDUCTOR WAFER**

(30) Priority: 20.07.2021 JP 2021119277
(71) Applicant: Resonac Corporation, Tokyo 105-7325 (JP)
(72) Inventor: MAKINO, Tatsuya, Tokyo 105-7325 (JP)
(74) Representative: Berggren Oy
(86) International application number: PCT/JP2022/026756
(87) International publication number: WO 2023/002846

(57) **Abstract**

An aspect of the present disclosure relates to a resin composition for a dicing protective layer, the resin composition containing an acrylic resin having a carboxy group and an organic solvent.

## Description

### Technical Field

The present disclosure relates to a resin composition for a dicing protective layer and a method for processing a semiconductor wafer.

### Background Art

Semiconductor devices are generally manufactured through the following steps. First, a semiconductor wafer is stuck to an adhesive sheet for dicing, and the semiconductor wafer in that state is singulated into semiconductor chips (dicing step). Thereafter, a pickup step, a pressure-bonding step, a die-bonding step, and the like are carried out, and semiconductor devices are produced.

In the dicing step, fine cuttings generated as a result of cutting of a semiconductor wafer may adhere to a circuit-forming surface of the semiconductor wafer, causing connection failure in the subsequent steps. Therefore, it has been considered to carry out a dicing step after providing a protective layer on a semiconductor wafer, and to remove the protective layer after dicing. For example, as a material used for forming a protective layer, Patent Literature 1 discloses a non-water-soluble polysaccharide having a sugar with a cyclic structure as a basic skeleton, and Patent Literature 2 discloses a copolymer including monomer constituent unit derived from an acid anhydride.

### Citation List

### Patent Literature

Patent Literature 1: JP 2014-172932 A
Patent Literature 2: JP 2018-129365 A

### Summary of Invention

### Technical Problem

A protective layer of a semiconductor wafer is required not to peel off from a semiconductor wafer during dicing or dissolve in the cooling water used during dicing. On the other hand, since the protective layer is removed after dicing, it is required to be dissoluble in an aqueous alkali solution used for removing the protective layer.

It is an object of the present disclosure to provide a resin composition for a dicing protective layer, the resin composition being capable of forming a protective layer that has excellent tight adhesiveness during dicing of a semiconductor wafer and also has excellent removability after dicing, and a method for processing a semiconductor wafer using the resin composition.

### Solution to Problem

An aspect of the present disclosure relates to the following resin composition for a dicing protective layer and the following method for processing a semiconductor wafer.
[1] A resin composition for a dicing protective layer, the resin composition comprising an acrylic resin having a carboxy group and an organic solvent.
[2] The resin composition according to the above-described item [1], wherein the acrylic resin has a structural unit derived from (meth)acrylic acid.
[3] The resin composition according to the above-described item [2], wherein the acrylic resin further has a structural unit derived from a (meth)acrylic acid alkyl ester.
[4] The resin composition according to any one of the above-described items [1] to [3], wherein the acrylic resin has a weight average molecular weight of 10000 to 100000.
[5] The resin composition according to any one of the above-described items [1] to [4], wherein the organic solvent includes at least one selected from the group consisting of a glycol ether-based solvent and an aliphatic carboxylic acid ester-based solvent.
[6] A method for processing a semiconductor wafer, the method comprising a step of forming a protective layer on a semiconductor wafer by using the resin composition for a dicing protective layer according to any one of the above-described items [1] to [5]; a step of dicing the semiconductor wafer on which the protective layer is formed; and a step of removing the protective layer from the diced semiconductor wafer by using an aqueous alkali solution.
[7] The method for processing a semiconductor wafer according to the above-described item [6], wherein the protective layer has a thickness of 0.3 to 3.0 µm.

### Advantageous Effects of Invention

According to the present disclosure, a resin composition for a dicing protective layer, the resin composition being capable of forming a protective layer that has excellent tight adhesiveness during dicing of a semiconductor wafer and also has excellent removability after dicing, and a method for processing a semiconductor wafer using the resin composition, can be provided.

### Description of Embodiments

The present disclosure will be described in detail below. However, the present invention is not intended to be limited to the following embodiment. In the present specification, the term "(meth)acrylic acid" means at least one of "acrylic acid" and "methacrylic acid" corresponding thereto, and the same also applies to other similar expressions such as (meth)acrylate. In addition, regarding the phrase "A or B", either A or B may be included, or both of them may be included. Furthermore, the term "solid content" refers to a non-volatile fraction excluding volatile substances such as water and a solvent included in a composition and refers to components remaining without volatilizing when the composition is dried, and the term also includes substances that are liquid, syrup-like, and waxy at room temperature near 25°C. Regarding the content of each component in the composition, in a case where a plurality of substances corresponding to each component are present in the composition, unless particularly stated otherwise, the content means the total amount of the plurality of substances present in the composition. Unless particularly stated otherwise, materials mentioned below as examples may be used singly, or two or more kinds thereof may be used in combination.

In the present specification, a numerical value range represented by using the term "to" represents a range including the numerical values described before and after the term "to" as the minimum value and the maximum value, respectively. With regard to numerical value ranges described stepwise in the present specification, the upper limit value or lower limit value of a numerical value range of a certain stage may be replaced with the upper limit value or lower limit value of a numerical value range of another stage. With regard to a numerical value range described in the present specification, the upper limit value or lower limit value of the numerical value range may be replaced with a value shown in the Examples.

### [Resin composition for dicing protective layer]

A resin composition according to the present embodiment contains an acrylic resin having a carboxy group (hereinafter, may be simply referred to as "acrylic resin".) and an organic solvent.

### (Acrylic resin)

The acrylic resin according to the present embodiment has a carboxy group, from the viewpoint of improving the solubility in an aqueous alkali solution. The carboxy group can be introduced by radical-polymerizing a monomer having a carboxy group.

Examples of the monomer having a carboxy group include (meth)acrylic acid, α-bromo(meth)acrylic acid, a-chloro(meth)acrylic acid, β-furyl(meth)acrylic acid, (3-styryl(meth)acrylic acid, fumaric acid, cinnamic acid, α-cyanocinnamic acid, itaconic acid, crotonic acid, and propiolic acid. From the viewpoint of increasing the solubility in an aqueous alkali solution, it is preferable that the acrylic resin has a structural unit derived from (meth)acrylic acid.

From the viewpoint of improving the balance between the water resistance during dicing and the solubility in an aqueous alkali solution, the content of the structural unit derived from (meth)acrylic acid may be 5 to 25% by mass, 8 to 20% by mass, or 10 to 15% by mass, based on the total mass of structural units derived from the monomers constituting the acrylic resin.

From the viewpoint of improving water resistance during dicing, the acrylic resin may further have a structural unit derived from a (meth)acrylic acid alkyl ester. The acrylic resin can be manufactured by, for example, radical-polymerizing (meth)acrylic acid and a (meth)acrylic acid alkyl ester.

Examples of the (meth)acrylic acid alkyl ester include methyl (meth)acrylate, ethyl (meth)acrylate, propyl (meth)acrylate, butyl (meth)acrylate, pentyl (meth)acrylate, hexyl (meth)acrylate, heptyl (meth)acrylate, octyl (meth)acrylate, nonyl (meth)acrylate, decyl (meth)acrylate, undecyl (meth)acrylate, dodecyl (meth)acrylate (lauryl (meth)acrylate), tridecyl (meth)acrylate, tetradecyl (meth)acrylate, pentadecyl (meth)acrylate, hexadecyl (meth)acrylate, heptadecyl (meth)acrylate, octadecyl (meth)acrylate, nonadecyl (meth)acrylate, and eicosyl (meth)acrylate.

From the viewpoint of further improving water resistance during dicing, the content of the structural unit derived from a (meth)acrylic acid alkyl ester may be 40% by mass or more, 50% by mass or more, or 55% by mass or more, based on the total mass of the structural units derived from the monomers constituting the acrylic resin. From the viewpoint of further improving solubility in an aqueous alkali solution, the content of the structural unit derived from a (meth)acrylic acid alkyl ester may be 90% by mass or less, 88% by mass or less, or 85% by mass or less, based on the total mass of the structural units derived from the monomers constituting the acrylic resin.

From the viewpoint of further improving water resistance during dicing, the acrylic resin may further have a structural unit derived from styrene or a styrene derivative. Examples of the styrene derivative include vinyltoluene, α-methylstyrene, p-methylstyrene, and p-ethylstyrene.

From the viewpoint of further increasing the solubility in an aqueous alkali solution, the acrylic resin may have a hydroxyl group. Examples of a monomer having a hydroxyl group include 2-hydroxyethyl (meth)acrylate, 2-hydroxypropyl (meth)acrylate, 3-hydroxypropyl (meth)acrylate, 4-hydroxybutyl (meth)acrylate, 2-hydroxybutyl (meth)acrylate, and glycerol mono(meth)acrylate.

The acrylic resin may have a structural unit other than the above-described structural units. Examples of a monomer providing such a structural unit include benzyl (meth)acrylate or a derivative thereof, acrylonitrile, tetrahydrofurfuryl (meth)acrylate, glycidyl (meth)acrylate, 2,2,2-trifluoroethyl (meth)acrylate, and 2,2,3,3-tetrafluoropropyl (meth)acrylate.

From the viewpoint of further increasing the solubility in an aqueous alkali solution, the acid value of the acrylic resin may be 50 mg KOH/g or more, 60 mg KOH/g or more, or 70 mg KOH/g or more, and from the viewpoint of increasing the water resistance during dicing, the acid value may be 150 mg KOH/g or less, 140 mg KOH/g or less, or 130 mg KOH/g or less.

The weight average molecular weight (Mw) of the acrylic resin may be 10000 to 100000, 15000 to 90000, 20000 to 80000, 30000 to 70000, or 40000 to 60000. When the Mw of the acrylic resin is 10000 or more, the film-forming properties are easily improved, and when the Mw is 100000 or less, the acrylic resin is easily removed by an aqueous alkali solution. Here, the Mw is a value obtained by making measurement by a gel permeation chromatography (GPC) method and performing calculation relative to a calibration curve based on polystyrene standards.

The content of the acrylic resin in the resin composition according to the present embodiment may be, for example, 5 to 30% by mass, 8 to 25% by mass, or 10 to 20% by mass.

### (Organic solvent)

Regarding the organic solvent according to the present embodiment, a solvent that can dissolve the acrylic resin and is easily removable when forming a protective layer, can be used. From the viewpoint of improving the film-forming properties of the resin composition, it is preferable that the organic solvent includes at least one selected from the group consisting of a glycol ether-based solvent and an aliphatic carboxylic acid ester-based solvent.

Examples of the glycol ether-based solvent include ethylene glycol monomethyl ether acetate, ethylene glycol monoethyl ether acetate, propylene glycol monomethyl ether acetate, propylene glycol monoethyl ether acetate, propylene glycol monopropyl ether acetate, propylene glycol monobutyl ether acetate, propylene glycol monomethyl ether, propylene glycol monoethyl ether, propylene glycol monopropyl ether, propylene glycol monobutyl ether, propylene glycol dimethyl ether, propylene glycol diethyl ether, propylene glycol dipropyl ether, and propylene glycol dibutyl ether.

Examples of the aliphatic carboxylic acid ester-based solvent include methyl lactate, ethyl lactate, n-propyl lactate, isopropyl lactate, ethyl acetate, n-propyl acetate, isopropyl acetate, n-butyl acetate, isobutyl acetate, n-amyl acetate, isoamyl acetate, isopropyl propionate, n-butyl propionate, and isobutyl propionate.

### (Leveling agent)

The resin composition according to the embodiment may further contain a leveling agent. By blending a leveling agent into the resin composition, striations (cissing, unevenness, and the like) can be prevented, and application properties on a semiconductor wafer can be improved.

Examples of the leveling agent include polyoxyethylene lauryl ether, polyoxyethylene stearyl ether, polyoxyethylene oleyl ether, and polyoxyethylene octylphenol ether. Examples of a commercially available product of the leveling agent include MEGAFAC F171, F173, and R-08 (manufactured by DIC Corporation, trade names); FLUORAD FC430 and FC431 (manufactured by Sumitomo 3M Limited, trade names); and Organosiloxane Polymer KP341, KBM303, KBM403, and KBM803 (manufactured by Shin-Etsu Chemical Co., Ltd., trade names).

The blending amount in the case of using a leveling agent may be 0.01 to 5 parts by mass, 0.03 to 3 parts by mass, or 0.05 to 2 parts by mass, with respect to 100 parts by mass of the acrylic resin.

### (Coupling agent)

The resin composition according to the present embodiment may further contain a coupling agent. By blending a coupling agent into the resin composition, peeling off of the protective layer during dicing is easily suppressed. Examples of the coupling agent include an organic silane compound and an aluminum chelate compound.

Examples of the organic silane compound include vinyltriethoxysilane, γ-glycidoxypropyltriethoxysilane, γ-methacryloxypropyltrimethoxysilane, urea propyltriethoxysilane, methylphenylsilanediol, ethylphenylsilanediol, n-propylphenylsilanediol, isopropylphenylsilanediol, n-butylphenylsilanediol, isobutylphenylsilanediol, tert-butylphenylsilanediol, diphenylsilanediol, ethylmethylphenylsilanol, n-propylmethylphenylsilanol, isopropylmethylphenylsilanol, n-butylmethylphenylsilanol, isobutylmethylphenylsilanol, tert-butylmethylphenylsilanol, ethyl-n-propylphenylsilanol, ethylisopropylphenylsilanol, n-butylethylphenylsilanol, isobutylethylphenylsilanol, tert-butylethylphenylsilanol, methyldiphenylsilanol, ethyldiphenylsilanol, n-propyldiphenylsilanol, isopropyldiphenylsilanol, n-butyldiphenylsilanol, isobutyldiphenylsilanol, tert-butyldiphenylsilanol, phenylsilanetriol, 1,4-bis(trihydroxysilyl)benzene, 1,4-bis(methyldihydroxysilyl)benzene, 1,4-bis(ethyldihydroxysilyl)benzene, 1,4-bis(propyldihydroxysilyl)benzene, 1,4-bis(butyldihydroxysilyl)benzene, 1,4-bis(dimethylhydroxysilyl)benzene, 1,4-bis(diethylhydroxysilyl)benzene, 1,4-bis(dipropylhydroxysilyl)benzene, and 1,4-bis(dibutylhydroxysilyl)benzene.

The blending amount in the case of using a coupling agent may be 0.1 to 10 parts by mass, 0.3 to 8 parts by mass, or 0.5 to 5 parts by mass, with respect to 100 parts by mass of the acrylic resin.

The protective layer formed on the semiconductor wafer by using the resin composition according to the present embodiment has excellent tight adhesiveness to the semiconductor wafer during dicing and can be easily removed by using an aqueous alkali solution after dicing.

### [Method for processing semiconductor wafer]

A method for processing a semiconductor wafer according to the present embodiment includes a step of forming a protective layer on a semiconductor wafer by using the above-mentioned resin composition for a dicing protective layer; a step of dicing the semiconductor wafer on which the protective layer is formed; and a step of removing the protective layer from the diced semiconductor wafer by using an aqueous alkali solution.

The method for forming a protective layer on a semiconductor wafer is not particularly limited, and the protective layer may be formed by applying the above-mentioned resin composition on a semiconductor wafer by a method such as spin coating and drying the resin composition, or the protective layer may be formed by forming a resin layer that serves as a protective layer on a release film, subsequently sticking the resin layer on a semiconductor wafer, and then peeling off the release film.

Since the protective layer according to the present embodiment has excellent tight adhesiveness and water resistance, the protective layer can protect the semiconductor wafer during dicing. From the viewpoint of increasing the protective properties during dicing, the thickness of the protective layer may be 0.3 µm or more, 0.5 µm or more, or 0.8 µm or more, and from the viewpoint of shortening the peeling time, the thickness may be 3.0 µm or less, 2.0 µm or less, or 1.5 µm or less. That is, the thickness of the protective layer may be 0.3 to 3.0 µm, 0.5 to 2.0 µm, or 0.8 to 1.5 µm.

Examples of the aqueous alkali solution used for removing the protective layer include an aqueous solution of ammonia and an aqueous solution of tetramethylammonium hydroxide (TMAH). The concentration of the aqueous alkali solution may be, in the case of an aqueous solution of ammonia, 0.01 to 5% by mass, 0.1 to 3.0% by mass or less, or 0.5 to 2.0% by mass, and in the case of an aqueous solution of TMAH, the concentration may be 0.1 to 10% by mass, 0.5 to 5% by mass or less, or 1.0 to 5.0% by mass. The removal of the protective layer may be carried out, for example, at 5 to 30°C for 5 to 300 seconds.

The processed semiconductor wafer after removing the protective layer can be used for connecting with another semiconductor wafer or a semiconductor chip. In the method for processing a semiconductor wafer according to the present embodiment, since fine cuttings generated by cutting of a semiconductor wafer can be prevented from adhering to the semiconductor wafer, the occurrence of connection failure in the subsequent steps can be reduced.

### Examples

Hereinafter, the present disclosure will be described specifically based on Examples; however, the present invention is not intended to be limited to the following Examples.

### [Synthesis of acrylic resin]

### (Synthesis Example 1)

Into a flask equipped with a stirrer, a cooler, a gas inlet tube, a dropping funnel, and a thermometer, 80 parts by mass of propylene glycol monomethyl ether acetate and 80 parts by mass of ethyl lactate were introduced, and the mixture was stirred at 80°C while introducing nitrogen gas thereinto. Next, a mixture of 26 parts by mass of methacrylic acid, 110 parts by mass of methyl methacrylate, and 64 parts by mass of butyl acrylate, which were monomers, as well as 3 parts by mass of 2,2'-azobis(isobutyronitrile) as a polymerization initiator, 44 parts by mass of propylene glycol monomethyl ether acetate, and 44 parts by mass of ethyl lactate, was added dropwise into the flask over 3 hours, and then, the mixture was stirred at 80°C for 4 hours and was further stirred at 100°C for 2 hours. Thereafter, the mixture was cooled to room temperature to obtain a solution (solid content 45% by mass) of acrylic resin (P-1). The Mw of P-1 was 43000.

The Mw of the acrylic resin is a value measured by GPC and calculated relatively by using a calibration curve of polystyrene standards. The Mw was measured by using "HLC-8320GPC" manufactured by Tosoh Corporation as a measuring apparatus, "Gelpack GL-A150-S/GL-A160-S" manufactured by Showa Denko Materials Co., Ltd. as a column, and tetrahydrofuran as an eluent, under the conditions of a flow rate of 1 mL/min and a column temperature of 40°C. The calibration curve was approximated by a cubic equation of a universal calibration curve in accordance with JIS K 7252-2 (2016) using a set of five standard polystyrene samples (PStQuick MP-H and PStQuick B manufactured by Tosoh Corporation).

### (Synthesis Example 2)

A solution of acrylic resin (P-2) was obtained in the same manner as in Synthesis Example 1, except that the monomers were changed to 26 parts by mass of acrylic acid, 60 parts by mass of styrene, and 114 parts by mass of butyl acrylate. The Mw of P-2 was 46000.

### (Synthesis Example 3)

A solution of acrylic resin (P-3) was obtained in the same manner as in Synthesis Example 1, except that the monomers were changed to 22 parts by mass of methacrylic acid, 34 parts by mass of 2-hydroxyethyl methacrylate, 42 parts by mass of methyl methacrylate, and 102 parts by mass of butyl acrylate. The Mw of P-3 was 44000.

### [Preparation of resin composition for dicing protective layer and formation of protective layer]

### (Example 1)

A resin composition was prepared by mixing 10 parts by mass of the solution of acrylic resin (P-1) and 20 parts by mass of ethyl lactate and filtering the mixture through a filter with a pore size of 0.5 µm.

The resin composition was spin-coated on a 6-inch silicon wafer (thickness 0.625 mm) at 25°C by using a spin coater (MIKASA CO., LTD., trade name "Opticoat MS-A200") under the conditions of 500 rpm/5 seconds and then 2000 rpm/30 seconds, the silicon wafer was heated for 2 minutes on a hot plate set at 100°C, and a protective layer having a thickness of 1.1 µm was formed on the silicon wafer.

### (Example 2)

A resin composition was prepared in the same manner as in Example 1, except that the solution of acrylic resin (P-1) was changed to the solution of acrylic resin (P-2), and a protective layer having a thickness of 1.2 µm was formed on a silicon wafer by using the resin composition.

### (Example 3)

A resin composition was prepared in the same manner as in Example 1, except that the solution of acrylic resin (P-1) was changed to the solution of acrylic resin (P-3), and a protective layer having a thickness of 1.2 µm was formed on a silicon wafer by using the resin composition.

### (Comparative Example 1)

A resin composition was prepared by mixing 20 parts by mass of a styrene-maleic anhydride copolymer (Polyscope Polymers B.V., trade name "XIRAN-1000", Mw: 5000) with 80 parts by mass of a 4% by mass aqueous solution of ammonia and filtering the mixture through a filter with a pore size of 0.5 µm. It was attempted to form a protective layer on a silicon wafer by using the resin composition; however, since cissing and unevenness occurred, a protective layer for evaluation could not be formed.

### (Comparative Example 2)

A resin composition was prepared by mixing 13 parts by mass of a styrene-maleic anhydride copolymer (Polyscope Polymers B.V., trade name "XIRAN-3000", Mw: 10000) with 87 parts by mass of a 4% by mass aqueous solution of ammonia and filtering the mixture through a filter with a pore size of 0.5 µm. A protective layer having a thickness of 0.9 µm was formed on a silicon wafer in the same manner as in Example 1, except that the resin composition was used.

### [Evaluation]

The following evaluations were performed on the silicon wafers on which a protective layer was formed. The results are shown in Table 1.

### (Appearance)

The appearance of the protective layer was checked by visual inspection, and a case in which the protective layer had no cissing and unevenness was considered as OK, while a case in which the protective layer had cissing or unevenness was considered as NG.

### (Dicing properties)

A silicon wafer having a protective layer formed thereon was diced such that the chip size was 5 mm in length and 5 mm in width, by using a dicing saw (DISCO Inc., trade name "DAD3350") and a dicing blade (Disco Corporation, trade name "ZH05-SD4500-N1-70-DD") under the conditions of a spindle rotations per minute of 30000 rpm and a feed rate of 50 mm/s. After dicing, the vicinity of an intersection of vertical and horizontal cutting lines of the protective layer was observed with a microscope. A case in which the protective film had no dissolution and peeling was considered as OK, and a case in which the protective layer had dissolution or peeling was considered as NG.

### (Solubility)

As aqueous alkali solutions, a 1.0% by mass aqueous solution of ammonia and a 2.38% by mass aqueous solution of TMAH were prepared. Protective layer-attached chips obtained by dicing were immersed in the aqueous alkali solutions at 23 °C, and the dissolution time of the protective film was measured. A case in which the dissolution time of the protective layer was 60 seconds or shorter was considered as OK, and a case in which the dissolution time of the protective layer was longer than 60 seconds was considered as NG.

**[Table 1]**

| | | Example | | | Comparative Example | |
|---|---|---|---|---|---|---|
| | | 1 | 2 | 3 | 1 | 2 |
| Thickness of protective layer (µm) | | 1.1 | 1.2 | 1.2 | - | 0.9 |
| Appearance of protective layer | | OK | OK | OK | NG | OK |
| Dicing properties | | OK | OK | OK | - | NG (peeled off) |
| Solubility | Aqueous solution of ammonia | OK | OK | OK | - | OK |
| | Aqueous solution of TMAH | OK | OK | OK | - | OK |

## Claims

1. A resin composition for a dicing protective layer, the resin composition comprising an acrylic resin having a carboxy group and an organic solvent.

2. The resin composition according to claim 1, wherein the acrylic resin has a structural unit derived from (meth)acrylic acid.

3. The resin composition according to claim 2, wherein the acrylic resin further has a structural unit derived from a (meth)acrylic acid alkyl ester.

4. The resin composition according to claim 1, wherein the acrylic resin has a weight average molecular weight of 10000 to 100000.

5. The resin composition according to claim 1, wherein the organic solvent includes at least one selected from the group consisting of a glycol ether-based solvent and an aliphatic carboxylic acid ester-based solvent.

6. A method for processing a semiconductor wafer, the method comprising:
a step of forming a protective layer on a semiconductor wafer by using the resin composition for a dicing protective layer according to any one of claims 1 to 5;
a step of dicing the semiconductor wafer on which the protective layer is formed; and
a step of removing the protective layer from the diced semiconductor wafer by using an aqueous alkali solution.

7. The method for processing a semiconductor wafer according to claim 6, wherein the protective layer has a thickness of 0.3 to 3.0 µm.
